# EUROPÄISCHE PATENTSCHRIFT

(11) **EP 3 694 062 B1**
(45) Veröffentlichungstag und Bekanntmachung des Hinweises auf die Patenterteilung: **07.04.2021**
(21) Anmeldenummer: 20151583.0
(22) Anmeldetag: 14.01.2020
(51) Int. Cl.: H01S 3/00, H01S 3/06, H01S 3/094, H01S 3/16

(54) **PASSIV GÜTEGESCHALTETER FESTKÖRPERLASER**
PASSIVELY Q-SWITCHED SOLID STATE LASER
LASER À SOLIDE COMMUTÉ PASSIVEMENT

(30) Priorität: 31.01.2019 AT 382019
(43) Veröffentlichungstag der Anmeldung: 12.08.2020
(73) Patentinhaber: Montfort Laser GmbH, 6840 Götzis (AT)
(72) Erfinder: Kopf, Daniel, 6832 Röthis (AT)
(74) Vertreter: Hofmann, Ralf U.

(56) Entgegenhaltungen:
- DE-A1-102010 021 262
- US-A1- 2018 309 261
- TÜRKYILMAZ ERDAL ET AL: "Simple ps microchip Nd:YVOlaser with 3.3-ps pulses at 0.2 to 1.4 MHz and single-stage amplification to the microjoule level", OPTICAL ENGINEERING, SOC. OF PHOTO-OPTICAL INSTRUMENTATION ENGINEERS, BELLINGHAM, Bd. 55, Nr. 6, 1. Juni 2016 (2016-06-01), Seite 66126, XP060073105, ISSN: 0091-3286, DOI: 10.1117/1.OE.55.6.066126 [gefunden am 2016-06-29]
- EVA MEHNER ET AL: "Sub-20-ps pulses from a passively Q-switched microchip laser at 1 MHz repetition rate", OPTICS LETTERS, OPTICAL SOCIETY OF AMERICA, US, Bd. 39, Nr. 10, 15. Mai 2014 (2014-05-15), Seiten 2940-2943, XP001589522, ISSN: 0146-9592, DOI: 10.1364/OL.39.002940 [gefunden am 2014-05-09]
- HEE CHUL LEE ET AL: "High-energy, sub-nanosecond linearly polarized passively Q-switched MOPA laser system", OPTICS AND LASER TECHNOLOGY, Bd. 95, 1. Oktober 2017 (2017-10-01), Seiten 81-85, XP055672589, NL ISSN: 0030-3992, DOI: 10.1016/j.optlastec.2017.04.024
- DRUON F ET AL: "HIGH-REPETITION-RATE 300-PS PULSED ULTRAVIOLET SOURCE WITH A PASSIVELY Q-SWITCHED MICROCHIP LASER AND A MULTIPASS AMPLIFIER", OPTICS LETTERS, OPTICAL SOCIETY OF AMERICA, US, Bd. 24, Nr. 7, 1. April 1999 (1999-04-01), Seiten 499-501, XP000829716, ISSN: 0146-9592
- JOE T. MOK ET AL: "Soliton compression and pulse-train generation by use of microchip Q-switched pulses in Bragg gratings", OPTICS LETTERS, Bd. 30, Nr. 18, 15. September 2005 (2005-09-15), Seite 2457, XP055701890, US ISSN: 0146-9592, DOI: 10.1364/OL.30.002457
- BHANDARI RAKESH ET AL: "Palm-top size megawatt peak power ultraviolet microlaser", OPTICAL ENGINEERING, SOC. OF PHOTO-OPTICAL INSTRUMENTATION ENGINEERS, BELLINGHAM, Bd. 52, Nr. 7, 1. Juli 2013 (2013-07-01), Seite 76102, XP060025946, ISSN: 0091-3286, DOI: 10.1117/1.OE.52.7.076102 [gefunden am 2013-07-01]
- KOHL HAGEN ET AL: "12-ps megawatt peak power pulses out of a single laser oscillator with nonlinear pulse compression", SPIE - INTERNATIONAL SOCIETY FOR OPTICAL ENGINEERING. PROCEEDINGS, S P I E - INTERNATIONAL SOCIETY FOR OPTICAL ENGINEERING, US, Bd. 10896, 7. März 2019 (2019-03-07), Seiten 108960K-108960K, XP060120743, ISSN: 0277-786X, DOI: 10.1117/12.2509978

## Beschreibung

Die Erfindung bezieht sich auf einen passiv gütegeschalteter Festkörperlaser, der einen Resonator, in dem ein aktives Lasermaterial angeordnet ist und der einen Auskoppel-Endspiegel zur Auskopplung von Laserpulsen aus dem Resonator aufweist, welche eine Pulsdauer von weniger als 1 ns aufweisen, eine optische Faser, in welche die aus dem Auskoppel-Endspiegel ausgekoppelten Laserpulse eingekoppelt werden, und ein gechirptes Volumen Bragg-Gitter umfasst, an welchem eine Reflektion der Laserpulse nach ihrem Durchlauf durch die optische Faser zur Verkürzung der Pulsdauer erfolgt, wobei die Pulsdauer nach der Reflektion am gechirpten Volumen Bragg-Gitter weniger als 30 ps beträgt.

Passiv gütegeschaltete Festkörperlaser werden in unterschiedlichen Anwendungsgebieten eingesetzt. Ein UV-Laser, der als Basis einen passiv gütegeschalteten Festkörperlaser mit einer hohen Pulsenergie aufweist, geht beispielsweise aus Bhandari R. und Taira T., "Palm-top size megawatt peak power ultraviolet microlaser", Optical Engineering, July 2013/Vol. 52(7), 076102-1 -076102-6 hervor. Um einen UV-Laser auszubilden, erfolgt eine Wellenlängenkonvertierung der vom Resonator ausgekoppelten Laserpulse in einem Lithium-Triborat-Kristall. Als aktives Lasermaterial im Resonator wird Nd:YAG verwendet und als passiver Güteschalter wird ein Absorber verwendet, der von einem dotierten Festkörpermaterial in Form von Cr:YAG gebildet wird. Mit einer Länge des Resonators von 10mm wird ein "free spectral range", also ein Abstand zwischen den Wellenlängen von möglichen benachbarten longitudinalen Moden erreicht, der so groß ist, dass nur einer der longitudinalen Moden derart nah am Verstärkungsmaximum bei 1064 nm liegt, dass dieser anschwingt. Mit diesem Laser wird vor der Wellenlängenkonvertierung eine hohe Pulsenergie von 3mJ bei einer Pulsdauer von 230 ps und einer relativ geringen Wiederholrate von 100 Hz erreicht. Die Auslegung des Resonators ist so, dass dieser optisch stabil ("stable resonator") ist. Die Ausbildung des Resonators kann monolitisch sein, in Form eines Mikrochip-Lasers, wobei beide Endspiegel plan sind und im Betrieb vom aktiven Lasermaterial eine thermische Linse mit sammelnder Wirkung ausgebildet wird.

Passiv gütegeschaltete Festkörperlaser mit "single longitudinal mode"-Betrieb und demgegenüber um etliche Größenordnungen kleineren Pulsenergien im Bereich von einigen 10 nJ sind in Form von sehr kleinen monolithischen Mikrochip-Lasern mit Nd:YVO4 als aktivem Lasermaterial bekannt, vgl. z.B. WO 2016/004446 A1. Die Resonatorlängen können hier kleiner als 150 µm sein und es kann eine Pulsdauer von weniger als 100 ps erreicht werden.

Aus Lee H.C. et al., "High energy, sub-nanosecond linearly polarized passively Q-switched MOPA laser system", Optics and Laser Technology 95 (2017) 81-85, geht ein passiv gütegeschalteter Nd:YAG/Cr:YAG-Laser mit stabilem Resonator hervor, dessen Ausgangspulse, welche ca. 2,5 mJ-Pulsenergie und eine Pulsdauer von ca. 550 ps aufweisen, nachverstärkt werden. Das aktive Lasermaterial und der Absorber weisen hier an ihren einander zugewandten Seiten gegensinnig im Brewster-Winkel angeordnete Flächen auf, um eine Polarisationsselektion des Laserstrahls zu bewirken.

Ein bedeutendes Anwendungsgebiet von Laserstrahlung ist die Mikromaterialbearbeitung von Metallen und Halbleitern. Wenn die Pulsdauer gegenüber den thermischen Relaxationszeiten kurz ist, führt dies zu einer Materialverdampfung vor der Übertragung auf das Phononensystems des Gitters, sodass eine solche Materialbearbeitung auch als "kalt" bezeichnet wird. Die Pulsdauer der Laserpulse muss hierbei meist im Bereich von 1 ps bis 20 ps liegen. Die Pulsenergie muss den µJ-Bereich erreichen. Die Pulswiederholraten liegen üblicherweise zwischen einigen kHz und einigen MHz und können einstellbar sein.

Auch bei bestimmten medizinischen Anwendungen können die geforderten Spezifikationen in diesem Bereich liegen.

Bekannte und kommerziell eingesetzte Laser mit diesen Spezifikationen sind modengekoppelte Laser, kombiniert mit regenerativen Verstärkern. Nachteilig an diesen Systemen ist es, dass diese relativ teuer und groß sind.

Weitere Entwicklungsarbeiten haben zu anders aufgebauten Lasersystemen geführt, bei denen gezeigt wurde, dass diese Spezifikationen erreicht werden können. Diese Systeme haben sich aber bislang noch nicht in industriellen Anwendungen etabliert. Ein Vorschlag besteht darin, als Basis einen passiv gütegeschalteten Mikrochip-Laser mit sehr kurzem Resonator heranzuziehen, um kurze Pulsdauern der emittierten Laserpulse zu erzielen, die im Weiteren nachverstärkt werden, um eine ausreichende Pulsenergie zu erreichen. Zur passiven Güteschaltung können hierbei sättigbare Halbleiterspiegel (SESAM) eingesetzt werden, welche die Länge des Resonators kaum verlängern. Es wurden hierbei Pulsdauern von bis zu unter 20 ps erreicht, vgl. Mehner E. et al., "Sub-20-ps pulses from a passively Q-switched microchip laser at 1 MHz repitition rate" OPTICS LETTERS, Vol. 39, NO. 10, May 15, 2014, 2940-2943.

Das Erreichen einer Pulsdauer von unter 20 ps mit Hilfe von Mikrochip-Lasern ist allerdings mit Schwierigkeiten und Einschränkungen verbunden. Zur Verbesserung wurde daher im Weiteren vorgeschlagen, die vom Mikrochip-Laser ausgegebenen Laserpulse vor der Verstärkung zu komprimieren. Aus Türkyilmaz E. et al., "Simple ps microchip Nd:YVO4 laser with 3.3-ps pulses at 0.2 to 1.4 MHz and single-stage amplification to the microjoule level", Optical Engineering, June 2016/Vol. 55(6), 066126-1- 066126-6, geht ein Laser der eingangs genannten Art hervor. Als Basis wird ein Mikrochip-Laser eingesetzt, der Nd:YVO₄ als aktives Lasermaterial und einen sättigbaren Halbleiterspiegel zur Güteschaltung aufweist. Um die Ausgangspulse des Mikrochip-Lasers zu komprimieren, erfolgt zunächst eine spektrale Verbreiterung, indem die Laserpulse durch eine optische Faser mit einer Länge von 50m geführt werden. In der Folge erfolgt eine Reflektion an einem gechirpten Volumen Bragg-Gitter ("chirped volume Bragg grating", CVBG), wodurch die eigentliche Verkürzung der Pulsdauer bewirkt wird. Die komprimierten Pulse werden in der Folge optisch verstärkt, um ausreichende Pulsenergien zu erhalten.

Aufgabe der Erfindung ist es einen passiv gütegeschalteten Festkörperlaser der eingangs genannten Art bereitzustellen, der bei einem sehr einfachen Aufbau vorteilhaft für die Mikromaterialbearbeitung einsetzbar ist. Erfindungsgemäß gelingt dies durch einen Laser mit den Merkmalen des Anspruchs 1.

Der Festkörperlaser, dessen Ausgangspulse in der Folge zur Verkürzung der Pulsdauer komprimiert werden, weist gemäß der Erfindung als aktives Lasermaterial Nd:YAG auf und im Resonator ist als sättigbarer Absorber Cr:YAG mit einer Transmission angeordnet, welche im ungesättigten Zustand weniger als 50%, vorzugsweise weniger als 30% beträgt. Die geometrische Resonatorlänge liegt im Bereich von 1mm bis 10mm, vorzugsweise 2mm bis 6mm. Die am Auskoppel-Endspiegel ausgekoppelten Laserpulse, welche in der Folge komprimiert werden, weisen eine Pulsenergie im Bereich von 1µJ bis 200 µJ, vorzugsweise 10 µJ bis 100 µJ, auf.

Beim erfindungsgemäßen Laser erfolgt eine Kompression der Pulsdauer von Pulsen mit einer so hohen Pulsenergie, dass die in ihrer Pulsdauer komprimierten Laserpulse in vorteilhafter Weise direkt für die Mikromaterialbearbeitung eingesetzt werden können, ohne jegliches Erfordernis einer weiteren Verstärkung, wodurch ein besonders einfaches und kompaktes Setup bereitgestellt werden kann.

Die Pulsdauer der am Auskoppel-Endspiegel ausgekoppelten Laserpulse liegt unter 1 ns, vorzugsweise unter 500 ps. Diese Laserpulse werden zunächst zur spektralen Verbreiterung in eine optische Faser eingekoppelt, deren Länge vorteilhafterweise im Bereich von 0,5m bis 5m, vorzugsweise im Bereich von 1m bis 3m liegt. Der Kerndurchmesser der optischen Faser beträgt günstigerweise mehr als 10 µm und weniger als 30 µm. Vorzugsweise liegt der Kerndurchmesser der optischen Faser im Bereich von 15 µm bis 20 µm. Derartige optische Fasern sind als "large mode area" (LMA) - Fibern bekannt. Insbesondere kann es sich um eine polarisationserhaltende Faser ("polarization-maintaining fiber", PM-Fiber) handeln.

Nach Durchlaufen der optischen Faser werden die Laserpulse einem gechirpten Volumen Bragg-Gitter ("chirped volume Bragg grating", CVBG) zugeführt, an welchem die Laserpulse reflektiert werden, wodurch die Verkürzung der Pulsdauer der spektral verbreiterten Laserpulse erreicht werden kann. Die Pulsdauer der Laserpulse am Ausgang beträgt weniger als 30 ps, vorzugsweise weniger als 20 ps. Die Pulsenergie der Laserpulse am Ausgang beträgt vorteilhafterweise mehr als 1 µJ. Auch eine Pulsenergie von mehr als 10 µJ kann vorteilhaft möglich sein.

Wenn in dieser Schrift von einer Pulsdauer die Rede ist, so wird diese jeweils als Halbwertsbreite des Pulses gemessen ("full duration at half maximum", FDHM).

Der Resonator kann monolithisch ausgebildet sein. Die Lasereinheit, deren ausgekoppelten Pulse in die optische Faser eingekoppelt werden, kann also als Mikrochip-Laser ausgebildet sein.

Das Pumpen des aktiven Lasermaterials kann vorteilhafterweise durch einen der Endspiegel des Resonators mittels einer Laserdiode erfolgen, insbesondere kontinuierlich. Die Pumpleistung liegt günstigerweise im Bereich von1-10 W. Der Pumpstrahl wird hierbei im aktiven Lasermaterial vorzugsweise auf einen Durchmesser von weniger als 200 µm fokussiert.

Weitere Vorteile und Einzelheiten der Erfindung werden im Folgenden anhand der beiliegenden Zeichnung erläutert. In dieser zeigen:
Fig. 1 eine schematische Darstellung eines ersten Ausführungsbeispiels der Erfindung;
Fig. 2 eine etwas modifizierte Ausführungsform der Erfindung;

Der Laser weist einen Resonator 1 auf, in welchem als aktives Lasermaterial 2 Nd:YAG angeordnet ist. Im Weiteren ist im Resonator 1 als sättigbarer Absorber Cr:YAG, genauer Cr⁴⁺:YAG, angeordnet.

Der Resonator 1 weist einen Endspiegel 4 auf, durch welchen hindurch die durch gestrichelte Linien angedeutete Pumpstrahlung 5 eingestrahlt wird. Der Endspiegel 4 ist also für den Lasermode im Resonator 1 hochreflektierend, während er für die Pumpstrahlung hochtransmittierend ist.

Auf der dem Endspiegel 4 gegenüberliegenden Seite weist der Resonator 1 einen Auskoppel-Endspiegel 6 auf. Durch diesen hindurch erfolgt die Auskopplung des Laserstrahls 7. Der Auskoppel-Endspiegel 6 ist für den Lasermode im Resonator 1 also teilreflektierend.

Beim Resonator 1 handelt es sich um einen linearen Resonator (=stehende Wellen Resonator). Die Länge a des Resonators 1 (=geometrische Länge oder Baulänge von Endspiegel zu Endspiegel) liegt im Bereich zwischen 1mm und 10mm, vorzugsweise im Bereich zwischen 2mm und 6mm.

Im Ausführungsbeispiel handelt es sich um einen optisch stabilen Resonator, wie dies bevorzugt ist.

Der Resonator 1 ist von seiner Länge a her so abgestimmt, dass ein longitudinaler Mode der Laserstrahlung gerade beim Verstärkungsmaximum des aktiven Lasermaterials 2 von 1064 nm liegt. Durch die Kürze des Resonators 1 ist der "free spectral range" so groß, dass die benachbarten longitudinalen Moden soweit außerhalb des Verstärkungsmaximums liegen, dass diese zumindest im Wesentlichen nicht anschwingen (d.h. ihre Energie beträgt weniger als 10% des Grundmodes), insbesondere gar nicht anschwingen (d.h. die Laserschwelle wird nicht überschritten). Der Laser weist im Betrieb also zumindest im Wesentlichen nur einen einzigen longitudinalen Mode auf. Vorteilhafterweise weist der Laser im Betrieb zumindest im Wesentlichen auch nur einen einzigen transversalen Mode auf.

Der sättigbare Absorber 3 bildet einen passiven Güteschalter für den Laser. Die Transmission des sättigbaren Absorbers 3 in seinem ungesättigten Zustand beträgt weniger als 50%, vorzugsweise weniger als 30%, und kann beispielsweise im Bereich von 10% liegen.

Durch die Kürze des Resonators 1 in Verbindung mit der hohen Absorption des sättigbaren Absorbers 3 im ungesättigten Zustand können Laserpulse mit einer kurzen Pulsdauer erzeugt werden, welche vorzugsweise weniger als 500 ps beträgt.

Im Ausführungsbeispiel sind das aktive Lasermaterial 2 und der Absorber 3 jeweils in einer sogenannten "flat-brewster"-Konfiguration geschnitten und poliert. Das aktive Lasermaterial 2 und der Absorber 3 stehen also an ihren zueinander gerichteten Seiten jeweils im Brewster-Winkel zur Achse 8 des Laserstrahls 7, wobei diese Seiten zumindest im Wesentlichen parallel zueinander liegen, und die gegenüberliegende Seiten stehen rechtwinkelig zur Achse 8 des Laserstrahls. Die Flat-Seite ist günstigerweise mit einer Antireflektionsbeschichtung für die Laserwellenlänge beschichtet (gegebenenfalls auch für die Wellenlänge der Pumpstrahlung). Die Brewster-Flächen sind nicht notwendigerweise beschichtet. Die beiden Brewster-Flächen lassen die p-Polarisation ungehindert durch, ergeben aber einen Verlust für die s-Polarisation. Damit wird erzwungen, dass der Resonator in der p-Polarisation läuft, sodass die s-Polarisation zumindest im Wesentlichen nicht anschwingt (d.h. die Energie beträgt weniger als 10%, vorzugsweise 1%, von derjenigen des Grundmodes der p-Polarisation), insbesondere gar nicht anschwingt (d.h. die Laserschwelle wird nicht überschritten).

Um einen Etalon-Effekt für die s-Polarisation zu vermeiden, der die Verluste für die s-Polarisation verringern oder ausschalten könnte, muss der Abstand zwischen den beiden Brewster-Flächen genau gewählt werden, sodass sich keine hohe Transmission der s-Polarisation für die Wellenlängen jener s-polarisierten Moden vorliegt, die dem Verstärkungsmaximum des aktiven Lasermaterials 2 nahe sind. Stattdessen oder zusätzlich kann auch eine gegenseitige leichte Verkippung der Brewster-Flächen vorgesehen sein.

Die Absorption kann bei einer solchen "flat-brewster"-Konfiguration des Absorbers 3 durch eine Verschiebbarkeit des Absorbers 3 rechtwinkelig zur Achse 8 des Laserstrahls 7 veränderbar ausgebildet sein.

Andererseits kann der Resonator 1 auch monolithisch ausgebildet sein.

Zum Pumpen des Lasers kann eine Laserdiode 9 eingesetzt werden. Die Pumpleistung liegt günstigerweise im Bereich von1-10 W, beispielsweise bei etwa 5 W. Die Pumpstrahlung weist beispielsweise eine Wellenlänge von 808 nm auf.
Der Pumpstrahl wird im Ausführungsbeispiel im aktiven Lasermaterial auf einen Durchmesser von weniger als 200 µm fokussiert.

Vorzugsweise wird kontinuierlich gepumpt.

Beispielsweise kann die von der Laserdiode abgegebene Pumpstrahlung in einen Lichtleiter 10 eingekoppelt werden. Die vom Lichtleiter 10 abgegebene abgestrahlte Pumpstrahlung wird mittels einer Linse 11 kollimiert und durch den Endspiegel 4 in das aktive Lasermaterial 2 eingestrahlt.

Der am Auskoppel-Endspiegel 6 ausgekoppelte von Laserpulsen gebildete Laserstrahl 7 wird mittels mindestens einer Linse 12 in eine optische Faser 13, insbesondere Glasfaser, eingekoppelt. Aufgrund der hohen Intensität der Laserstrahlung in der optischen Faser 13 wird durch den Selbstphasen-Modulationseffekt ("self phase modulation", SPM) das Wellenlängenspektrum eines jeweiligen Laserpulses verbreitert, wobei es auch zu einem räumlichen Auseinanderlaufen der verschiedenen spektralen Anteile kommt. Die Länge der optischen Faser 13 liegt vorteilhafterweise im Bereich von 0,5m bis 5m, vorzugsweise im Bereich von 1m bis 3m, beispielsweise bei 2m. Insbesondere handelt es sich um eine "large mode area"-Faser (LMA-Fiber). Der Kerndurchmesser kann beispielsweise im Bereich von 15 µm bis 20 µm liegen.

Idealerweise wird der Grundmode der Faser angeregt.

Zur Vermeidung von Rückreflexen ist die Eintrittsfacette der optischen Faser 13 vorzugsweise so gecleaved, dass sie schräg zur Ausrichtung rechtwinkelig zur Achse des Laserstrahls steht, beispielsweise unter einem Winkel von 8°.

Der aus der Faser ausgekoppelte Laserstrahl wird durch mindestens eine Linse 14 kollimiert und nach Durchlaufen eines Polarisators 15 und eines λ/4-Plättchens 16 an einem gechirpten Volumen Bragg-Gitter 17 reflektiert, wobei die Pulsdauer eines jeweiligen Laserpulses verkürzt wird. Der reflektierte Laserstrahl durchläuft wiederum das λ/4-Plättchen 16 und wird in der Folge, da die Polarisationsrichtung gegenüber dem ersten Durchlaufen durch den Polarisator 15 um 90° gedreht ist, am Polarisator 15 reflektiert.

Die Pulse des austretenden Laserstrahls weisen eine Pulsdauer auf, welche weniger als 30 ps, vorzugsweise weniger als 20 ps beträgt. Die Pulsenergien der austretenden Pulse betragen vorzugsweise mehr als 1 µJ. Eine nachgeschaltete Verstärkung, um den austretenden Laserstrahl zur Mikromaterialbearbeitung einzusetzen, kann somit entfallen.

Die Pulswiederholrate liegt günstigerweise im Bereich von 1 kHz bis 100 kHz.

Im Ausführungsbeispiel trifft der Laserstrahl rechtwinkelig auf das gechirpte Volumen Bragg-Gitter 17 auf, der Einfallswinkel und der Ausfallswinkel beträgt somit jeweils 0°. Möglich wäre auch ein Auftreffen unter einem Winkel ungleich 0°. Der reflektierte Laserstrahl würde dann durch die Reflektion vom eintreffenden Laserstrahl örtlich getrennt. Der Polarisator 15 und das λ/4-Plättchen 16 könnten bei einer solchen Ausbildung auch entfallen.

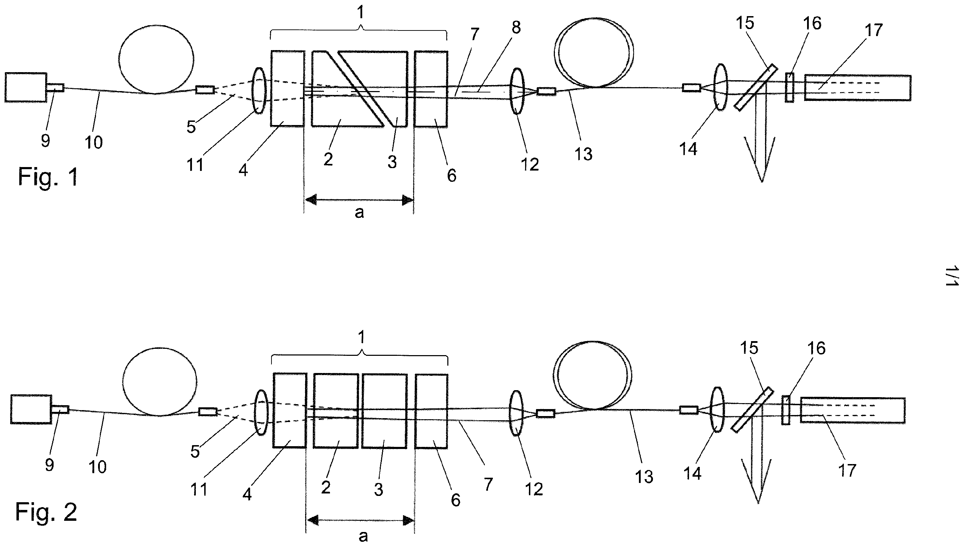

Ein zweites, etwas modifiziertes Ausführungsbeispiel ist in Fig. 2 dargestellt. Der Unterschied zum ersten Ausführungsbeispiel besteht darin, dass hier die Brewster-Winkel am aktiven Lasermaterial 2 und am sättigbaren Absorber 3 entfallen. Eine Selektion der gewünschten Polarisation des Laserstrahls könnte dann in anderer Weise durchgeführt werden. Hierzu könnte z.B. ein Element des Resonators eine Gitterstruktur aufweisen, deren Transmission sich für unterschiedliche Polarisationsrichtungen unterscheidet. Beispielsweise könnte einer der Endspiegel 4, 6 mit einer eine solche Gitterstruktur aufweisenden Beschichtung versehen sein. Auch durch eine entsprechende Wahl der Orientierung der Kristalle des aktiven Lasermaterials 2 und des sättigbaren Absorbers 3 und/oder durch gezielte Ausübung eines mechanischen Drucks auf das aktive Lasermaterial 2 und/oder den sättigbaren Absorber 3 kann eine solche Polarisationsselektion erreicht werden. Denkbar und möglich wäre es auch, auf eine Polarisationsselektion zu verzichten. Die Auskopplung des Laserstrahls nach der Reflektion am gechirpten Volumen Bragg-Gitters 17 könnte dann in anderer Weise als durch einen Polarisator erfolgen, beispielsweise durch einen Einfall des Laserstrahls auf das gechirpte Volumen Bragg-Gitter 17 unter einem Winkel ungleich 0°.

### Legende zu den Hinweisziffern:

1 Resonator
2 aktives Lasermaterial
3 sättigbarer Absorber
4 Endspiegel
5 Pumpstrahlung
6 Auskoppel-Endspiegel
7 Laserstrahl
8 Achse
9 Laserdiode
10 Lichtleiter
11 Linse
12 Linse
13 optische Faser
14 Linse
15 Polarisator
16 λ/4-Plättchen
17 gechirptes Volumen Bragg-Gitter

## Patentansprüche

1. Passiv gütegeschalteter Festkörperlaser umfassend
- einen Resonator (1), in dem ein aktives Lasermaterial (2) angeordnet ist und der einen Auskoppel-Endspiegel (6) zur Auskopplung von Laserpulsen aus dem Resonator (1) aufweist, welche eine Pulsdauer von weniger als 1 ns aufweisen,
- eine optische Faser (13), in welche die aus dem Auskoppel-Endspiegel (6) ausgekoppelten Laserpulse eingekoppelt werden,
- ein gechirptes Volumen Bragg-Gitter (17), an welchem eine Reflektion der Laserpulse nach ihrem Durchlauf durch die optische Faser (13) zur Verkürzung der Pulsdauer erfolgt, wobei die Pulsdauer nach der Reflektion am gechirpten Volumen Bragg-Gitter (17) weniger als 30 ps beträgt,
wobei das im Resonator (1) angeordnete aktive Lasermaterial (2) Nd:YAG ist und im Resonator im Weiteren einen von Cr:YAG gebildeter sättigbarer Absorber (3) angeordnet ist, der eine Transmission im ungesättigten Zustand von weniger als 50% aufweist, wobei die Länge (a) des Resonators (1) im Bereich von 1mm bis 10mm liegt und die am Auskoppel-Endspiegel (6) des Resonators (1) ausgekoppelten Laserpulse eine Pulsenergie im Bereich von 1 µJ bis 200 µJ aufweisen.

2. Festkörperlaser nach Anspruch 1, wobei die optische Faser (13) einen Kerndurchmesser von mehr als 10 µm aufweist.

3. Festkörperlaser nach Anspruch 2, wobei die optische Faser (13) eine polarisationserhaltende Faser ist.

4. Festkörperlaser nach einem der Ansprüche 1 bis 3, wobei die Länge der optischen Faser (13) im Bereich von 0,5m bis 5m liegt.

5. Festkörperlaser nach einem der Ansprüche 1 bis 4, wobei die zueinander gerichteten Seiten des aktiven Lasermaterials (2) und des sättigbaren Absorbers (3) jeweils im Brewster-Winkel zur Achse (8) des Laserstrahls (7) stehen, wobei sie gegenüber einer Ausrichtung rechtwinkelig zur Achse (8) des Laserstrahls gleichsinnig geneigt sind.

6. Festkörperlaser nach einem der Ansprüche 1 bis 5, wobei der Einfalls- und Ausfallswinkel des Laserstrahls auf das gechirpte Volumen Bragg-Gitter (17) 0° beträgt.

7. Festkörperlaser nach Anspruch 6, wobei die Auskopplung der Laserpulse nach der Reflektion am gechirpten Volumen Bragg-Gitter (17) durch einen Polarisator (15) erfolgt, wobei zwischen dem gechirpten Volumen Bragg-Gitter (17) und dem Polarisator (15) ein λ/4-Plättchen (16) angeordnet ist.

8. Festkörperlaser nach einem der Ansprüche 1 bis 7, wobei das Pumpen des aktiven Lasermaterials (2) mittels einer Laserdiode (9) durch den dem Auskoppel-Endspiegel (6) gegenüberliegenden Endspiegel (4) des Resonators (1) erfolgt.

9. Festkörperlaser nach Anspruch 8, wobei das Pumpen des aktiven Lasermaterials (2) kontinuierlich erfolgt.

10. Festkörperlaser nach einem der Ansprüche 1 bis 9, wobei im Resonator (1) zumindest im Wesentlichen nur ein einziger longitudinaler Mode anschwingt.

## Claims

1. Passively q-switched solid state laser comprising
- a resonator (1) in which an active laser material (2) is arranged, and which has an uncoupling end mirror (6) for uncoupling laser pulses from the resonator (1) which have a pulse duration of less than 1 nanosecond,
- an optical fibre (13) into which the laser pulses uncoupled from the uncoupling end mirror (6) are coupled,
- a chirped volume Bragg grating (17) on which a reflection of the laser pulses takes place after they have passed through the optical fibre (13) to shorten the duration of the pulse, wherein the pulse duration is less than 30 picoseconds after the reflection on the chirped volume Bragg grating (17),
wherein the active laser material (2) arranged in the resonator (1) is Nd:YAG and, furthermore, a saturable absorber (3) formed from Cr:YAG is arranged in the resonator, said absorber having a transmission in the unsaturated state of less then 50% wherein the length (a) of the resonator (1) is in the range of 1mm to 10mm and the laser pulses uncoupled at the uncoupling end mirror (6) of the resonator (1) have a pulse energy in the range of 1 µJ to 200 µJ.

2. Solid state laser according to claim 1, wherein the optical fibre (13) has a core diameter greater than 10 µm.

3. Solid state laser according to claim 2, wherein the optical fibre (13) is a polarisation-maintaining fibre.

4. Solid state laser according to any one of claims 1 to 3, wherein the length of the optical fibre (13) is in the range of 0.5m to 5m.

5. Solid state laser according to any one of claims 1 to 4, wherein the mutually aligned sides of the active laser material (2) and of the saturable absorber (3) are each at a Brewster angle to the axis (8) of the laser beam (7) wherein they are inclined in the same direction as opposed to being aligned at right angles to the axis (8) of the laser beam.

6. Solid state laser according to any one of claims 1 to 5, wherein the entry angle and the exit angle of the laser beam on the chirped volume Bragg grating (17) is 0°.

7. Solid state laser according to claim 6, wherein the uncoupling of the laser pulses takes place after the reflection on the chirped volume Bragg grating (17) by a polariser (15), wherein a λ/4 disk (16) is arranged between the chirped volume Bragg grating (17) and the polariser (15).

8. Solid state laser according to any one of claims 1 to 7, wherein the pumping of the active laser material (2) by means of a laser diode (9) is achieved by the end mirror (4) of the resonator (1) opposite the uncoupling end mirror (6).

9. Solid state laser according to claim 8, wherein the pumping of the active laser material (2) takes place continuously.

10. Solid state laser according to any one of claims 1 to 9, wherein at least essentially only one single longitudinal mode oscillates in the resonator (1).

## Revendications

1. Laser solide à commutation Q passive comprenant
- un résonateur (1) dans lequel est disposé un matériau laser actif (2) et qui comporte un miroir d'extrémité de couplage (6) pour sortir du résonateur (1) des impulsions laser qui ont une durée d'impulsion inférieure à 1 ns,
- une fibre optique (13) dans laquelle sont injectées les impulsions laser sortant du miroir d'extrémité de couplage (6)
- un réseau de Bragg en volume modulé (17) sur lequel se produit une réflexion des impulsions laser après leur passage à travers la fibre optique (13) en vue de raccourcir la durée des impulsions, la durée des impulsions après réflexion sur le réseau de Bragg en volume modulé (17) étant inférieure à 30 ps,
le matériau laser actif (2) disposé dans le résonateur (1) étant du Nd:YAG, et un absorbeur saturable (3) formé par du Cr:YAG étant en outre disposé dans le résonateur et présentant une transmission à l'état non saturé inférieure à 50 %, la longueur (a) du résonateur (1) étant située dans la fourchette comprise entre 1 mm et 10 mmm et les impulsions laser sortant du miroir d'extrémité de couplage (6) du résonateur (1) ayant une énergie d'impulsion située dans la fourchette comprise entre 1 µJ et 200 µJ. 20

2. Laser solide selon la revendication 1, dans lequel la fibre optique (13) a un diamètre de cœur supérieur à 10 µm.

3. Laser solide selon la revendication 2, dans lequel la fibre optique (13) est une 25 fibre à maintien de polarisation.

4. Laser solide selon l'une des revendications 1 à 3, dans lequel la longueur de la fibre optique (13) est située dans la fourchette comprise entre 0,5 m et 5 m.

5. Laser solide selon l'une des revendications 1 à 4, dans lequel les faces en regard du matériau laser actif (2) et de l'absorbeur saturable (3) sont placées chacune sous l'angle de Brewster par rapport à l'axe (8) du faisceau laser (7), et elles sont inclinées dans la même direction par rapport à une orientation perpendiculaire à l'axe (8) du faisceau laser.

6. Laser solide selon l'une des revendications 1 à 5, dans lequel l'angle d'incidence et l'angle de réflexion du faisceau laser sur le réseau de Bragg (17) en volume modulé est de 0°.

7. Laser solide selon la revendication 6, dans lequel la sortie des impulsions laser après la réflexion sur le réseau de Bragg en volume modulé (17) est réalisée par un polariseur (15), une lame λ/4 (16) étant disposée entre le réseau de Bragg en volume modulé (17) et le polariseur (15).

8. Laser solide selon l'une des revendications 1 à 7, dans lequel le pompage du matériau laser actif (2) est réalisé au moyen d'une diode laser (9) à travers le miroir d'extrémité (4) du résonateur (1) opposé au miroir d'extrémité de couplage (6).

9. Laser solide selon la revendication 8, dans lequel le pompage du matériau laser actif (2) est réalisé en continu.

10. Laser solide selon l'une des revendications 1 à 9, dans lequel pour l'essentiel un seul mode longitudinal oscille dans le résonateur (1).
